# EUROPÄISCHE PATENTSCHRIFT

(11) **EP 0 330 933 B1**
(45) Veröffentlichungstag und Bekanntmachung des Hinweises auf die Patenterteilung: **18.08.1993**
(21) Anmeldenummer: 89102748.4
(22) Anmeldetag: 17.02.1989
(51) Int. Cl.: G01R 21/02, G01K 17/00

(54) **Anordnung zum Messen der Energie eines Mikrowellenpulse**
Arrangement for measuring the energy of a microwave pulse
Dispositif pour mesurer l'énergie d'une impulsion micro-onde

(30) Priorität: 02.03.1988 CH 756/88
(43) Veröffentlichungstag der Anmeldung: 06.09.1989
(73) Patentinhaber: ASEA BROWN BOVERI AG, 5400 Baden (CH)
(72) Erfinder: Mathews, Hans-Günter, Dr., CH-5422 Oberehrendingen (CH); Schafheitle, Oskar, CH-8955 Oetwil a.d. L. (CH)

(56) Entgegenhaltungen:
- GB-A- 2 144 275
- US-A- 3 670 570
- REV. SCI. INSTRUM., Band 57, Nr. 5, Mai 1986, Seiten 855-858, American Institute of Physics, New York, US; C.B. WHARTON et al.: "Calorimetricmeasurements of single-pulse high-power microwaves in oversized waveguides"
- REVIEW ARTICLE, Band 6, Nr. 2, Februar 1973, Seiten 105-114; S.R. GUNN: "Calorimetric measurements of laser energy and power"

## Beschreibung

### Technisches Gebiet

Die Erfindung betrifft eine Anordnung zum Messen der Energie eines Mikrowellenpulses nach dem Oberbegriff des Anspruchs 1.

### Stand der Technik

Eine solche Anordnung ist aus dem Artikel "Calorimetric measurements of single-pulse high-power microwaves in over-sized waveguides" von C.B. Wharton in Review of Scientific Instruments 57 (1986) May, No. 5, Woodbury, New York, USA, bekannt.

Die oben genannte Anordnung umfasst ein Gehäuse, welches mit einem für Mikrowellen durchlässigen Fenster abgeschlossen ist und ein Gas enthält, welches Mikrowellen absorbiert und an welches ein Mikrowellenleiter angekoppelt werden kann. In einem abgeschlossenen Volumen im Gehäuse ist ein zweites Gas vorhanden, welches sich bei der Absorption eines Mikrowellenpulses im ersten Gas ausdehnt. Die Volumen-Ausdehnung dieses zweiten Gases dient als Mass der Energie des Mikrowellenpulses.

Im Hinblick auf die kontrollierte Kernfusion kommt der Mikrowellentechnik hoher Leistung im Bereich einiger weniger bis einiger 100 GHz grosse Bedeutung zu. Messtechnisch gesehen stellt dabei die Messung von Energie resp. Leistung eines Mikrowellenpulses ein Problem dar. Heute werden dafür meistens kalorimetrische Messverfahren eingesetzt. Die Grundzüge solcher Messverfahren werden z.B. im Buch "Mikrowellen Messtechnik", Horst Groll, Friedrich Vieweg + Sohn, Braunschweig, beschrieben.

Ein sogenanntes Hochleistungskalorimeter für Mikrowellen hoher Frequenz ist z.B. aus US 4,593,259 bekannt. In einem metallischen Gefäss ist eine Absorberflüssigkeit, welche durch eine Pumpe umgewälzt wird. Gemessen wird an einem Gefässausgang die Temperatur der Absorberflüssigkeit und die Durchflussmenge. Durch die eingestrahlte und absorbierte Mikrowellenleistung wird das Gefäss und die Flüssigkeit erwärmt. Aus der Durchflússmenge und der Erhöhung der Temperatur kann die absorbierte Leistung, oder wenn über die Zeit integriert wird, die absorbierte Energie bestimmt werden.

Ein solches Hochleistungskalorimeter eignet sich jedoch nicht zum Messen einzelner Mikrowellenpulse. Bei geringer absorbierter Energie ist nämlich der Temperaturanstieg in der Absorberflüssigkeit zu klein, um noch detektiert werden zu können.

### Darstellung der Erfindung

Aufgabe der Erfindung ist es daher, eine Anordnung zur Messung der Energie eines Mikrowellenpulses anzugeben, welches insbesondere zum Messen kleiner Energien geeignet ist.

Diese Aufgabe wird durch die Merkmale des Anspruches 1 gelöst.

Als Absorberflüssigkeit wird ein nichtgasendes Oel verwendet.

Bevorzugte Ausführungsformen ergeben sich aus den abhängigen Ansprüchen.

### KURZE BESCHREIBUNG DER ZEICHNUNG

Nachfolgend soll die Erfindung anhand von Ausführungsbeispielen und im Zusammenhang mit der Zeichnung näher erläutert werden. Es zeigen:
- Fig. 1: einen Schnitt durch eine Anordnung mit einem Reflexionskonus;
- Fig. 2: einen Axialschnitt durch eine Anordnung mit einem Gefäss, bei welchem das HF-Fenster durch eine konische Einbuchtung gebildet wird;
- Fig. 3: einen Axialschnitt durch eine Anordnung mit einem Gefäss, bei welchem das HF-Fenster durch eine Einbuchtung mit einem M-förmigen Axialschnitt gebildet wird; und
- Fig. 4: eine Anordnung für einen rechteckigen Wellenleiter.

### WEGE ZUR AUSFÜHRUNG DER ERFINDUNG

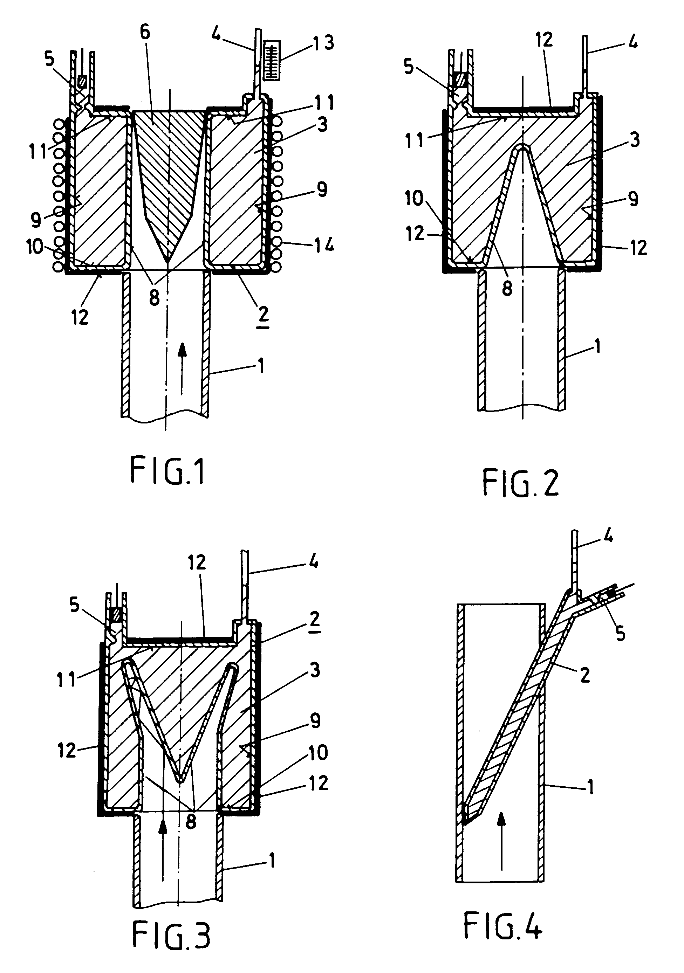

Fig. 1 zeigt einen Schnitt durch eine bevorzugte Anordnung.

Die erfindungsgemässe Anordnung ist an einem Ende eines Wellenleiters 1 koaxial zu diesem angeordnet. Sie umfasst ein Gefäss 2, welches mit einer Absorberflüssigkeit 3 gefüllt ist, eine Kapillare 4 und ein Ausgleichsvolumen 5, welche beide mit dem Gefäss 2 in Verbindung stehen. Ferner weist sie gemäss einer bevorzugten Ausführungsform einen Reflektorkonus 6 auf.

Das Gefäss 2 hat die Form eines Zylindermantels. D.h. ein Volumen des Gefässes 2 wird begrenzt durch eine zylinderförmige Innenwand 8, eine dazu koaxial angeordnete, zylinderförmige Aussenwand 9 und je ein ringförmig ausgebildeter Boden 10 und eine entsprechende Decke 11, welche das Volumen in axialer Richtung abschliessen. Der Durchmesser der Innenwand entspricht im wesentlichen dem Durchmesser des Wellenleiters 1.

Das Gefäss 2 besteht z.B. aus Quarz oder Glas und hat eine Wandstärke, die vorzugsweise kleiner als 1/4 einer Wellenlänge eines eingestrahlten Mikrowellenpulses ist. Dadurch kann erreicht werden, dass das Gefäss 2 für den Mikrowellenpuls transparent ist.

Der Reflektorkonus 6 hat die Aufgabe, den Mikrowellenpuls so zu streuen, dass seine Energie möglichst gleichmässig auf das Volumen des Gefässes 2, und damit auf die Absorberflüssigkeit 3, verteilt wird. Im allgemeinen wird es dazu unumgänglich sein, seine Form speziell auf den Mikrowellenpuls, d.h. eine geleitete Mode des Wellenleiters 1, auszulegen. In Fig. 1 ist der Reflektorkonus 6 gemäss einer bevorzugten Ausführungsform zweistufig ausgebildet. An seinem spitzen Ende hat er dabei einen grösseren Neigungswinkel als an seinem stumpfen Ende.

Die Aussenwand 9, der Boden 10 und die Decke 11 des Gefässes 2 sind mit einer Reflexionsschicht 12 bedeckt, welche verhindert, dass ein noch nicht absorbierter Teil des vom Reflektorkonus 6 gestreuten Mikrowellenpulses das Gefäss nach aussen verlassen kann.

Die Innenwand 8 dient als HF-Fenster. Sie sollte natürlich den gestreuten Mikrowellenpuls möglichst ungeschwächt durchlassen. Es wird aber nicht zu vermeiden sein, dass ein Teil des Mikrowellenpulses von der Innenwand 8 reflektiert wird und erneut vom Reflektorkonus 6 gestreut wird. Durch eine geeignet gewählte Form dieses Reflektorkonus 6 können und sollen solche Hin- und Her-Reflexionen auf ein Minimum herabgesetzt werden.

Im vorliegenden Ausführungsbeispiel ist an der Decke 11 des Gefässes 2 die Kapillare 4 angebracht. Eine Steighöhe der Absorberflüssigkeit 3 in der Kapillare 4 kann z.B. an einer Skale 13 abgelesen werden. Das Ausgleichsvolumen 5 ist dazu da, die Steighöhe zu nivellieren. In Fig. 1 wird diese Möglichkeit das Ausgleichsvolumen zu verändern mit einem Kolben angedeutet.

Um die Messgenauigkeit zu erhöhen, wird das Gefäss 2 mit Vorteil auf einer konstanten Arbeitstemperatur gehalten. Dazu kann es z.B. von einer Kühlschlange 14 umwickelt sein, welche verhindert, dass sich die Anordnung über die Umgebungstemperatur hinaus erwärmt. Störende Abstrahlungs- resp. Einstrahlungseffekte können dadurch vermieden werden.

Die Funktionsweise der beschriebenen Anordnung liegt auf der Hand.

Ein Mikrowellenpuls (siehe Pfeil), welcher sich im Wellenleiter 1 ausbreitet, trifft auf den Reflektorkonus 6 und wird in radialer Richtung gestreut. Ein grosser Teil des Mikrowellenpulses tritt durch die Innenwand 8 d.h. das HF-Fenster ins Gefäss 2 ein, wo er von der Absorberflüssigkeit 3 absorbiert wird. Im allgemeinen wird ein kleiner Teil des Mikrowellenpulses von der Innenwand 8 und dann vom Reflektorkonus 6 reflektiert werden und so erst im zweiten oder dritten Anlauf ins Gefäss 2 eindringen.

Wegen der absorbierten Energie des Mikrowellenpulses erwärmt sich die Absorberflüssigkeit 3 zumindest bereichsweise und dehnt sich entsprechend aus. Eine solche thermische Volumenausdehnung wird mit der Kapillare 4 gemessen.

Im folgenden sollen noch einige Einzelheiten des erfindungsgemässen Verfahrens resp. der Anordnung besprochen werden.

Ein besonderes Augenmerk ist auf die Absorberflüssigkeit 3 zu richten. Einerseits soll sie in einem gegebenen Wellenlängenbereich gut absorbieren, andererseits darf sie aber nicht gasen. Bilden sich aufgrund einer lokalen Ueberhitzung nämlich Gasblasen, dann ist die thermische Volumenausdehnung der Absorberflüssigkeit 3 als Ganzes hochgradig nicht linear. Die Steighöhe in der Kapillare 4 lässt nicht mehr eindeutig auf eine Erhöhung des Wärmegehalts d.h. auf die absorbierte Energie schliessen. In der Praxis führt eine gasende Absorberflüssigkeit 3 dazu, dass die Steighöhe überschwingt.

Um diese Schwierigkeiten zu vermeiden, werden bevorzugterweise z.B. Hydrauliköle oder Vakuumöle als Absorberflüssigkeit 3 verwendet. Diese sind dafür bekannt, dass sie nur eine geringe Neigung zum Gasen haben.

Eine weitere Massnahme besteht darin, eine Absorberflüssigkeit 3 einzusetzen, in welcher der Mikrowellenpuls eine hohe Eindringtiefe besitzt. In einem gegebenen Volumenelement wird dann weniger Energie absorbiert, was die Gefahr einer lokalen Ueberhitzung verringert.

Das Gefäss 2 wird mit Vorteil so dick (d.h. radialer Abstand der Aussenwand 9 zur Innenwand 8) bemessen, dass sich der gestreute Mikrowellenpuls spätestens nach zweimaligem Durchlaufen des Gefässes, d.h. wenn er nach einer Reflexion an der verspiegelten Aussenwand 9 erneut zur Innenwand 8 gelangt ist, totgelaufen hat.

Ein grosser Vorteil der Erfindung liegt darin, dass die Messung kein thermisches Gleichgewicht voraussetzt. Solange nämlich die thermische Volumenausdehnung linear wächst mit der Zunahme des Wärmegehaltes resp. der absorbierten Energie, kommt es für die Steighöhe nicht darauf an, ob sich ein kleiner Teil der Absorberflüssigkeit 3 lokal relativ stark erwärmt, oder ob sich ein entsprechend grosser Teil nur schwach erwärmt.

Von dieser Tatsache kann Gebrauch gemacht werden, wenn das Volumen des Gefässes 2 gross gehalten wird. Eine solche Massnahme hat zur Folge, dass sich die Gleichgewichtstemperatur der Absorberflüssigkeit 3 nach der Absorption eines Mikrowellenpulses von der Gleichgewichtstemperatur vor der Absorption (Arbeitstemperatur) nur wenig unterscheidet. Störeffekte, wie z.B. die thermische Abstrahlung oder eine Abgabe der Wärme über die Aussenwand können sich gar nicht erst entfalten.

Ein Zahlenbeispiel soll das soeben Gesagte verdeutlichen. Für einen Mikrowellenpuls mit einer Energie von etwa 10 J sollte das Volumen der Absorberflüssigkeit etwa 1 - 2 l betragen. Bei einer spezifischen Wärme von ca. 2.1 J/gK ergibt sich dann eine Erhöhung der Gleichgewichtstemperatur um etwa 1/400 K. Die Gleichgewichtstemperatur nach der Absorption der Energie ist damit bezogen auf die Arbeitstemperatur vernachlässigbar klein.

Das Volumen der Absorberflüssigkeit hat aber auch eine Bedeutung im Zusammenhang mit der Stabilisierung der Arbeitstemperatur. Die Kühlschlange 14 z.B. sollte die Arbeitstemperatur konstant halten, d.h. die absorbierte Energie abführen, sie darf das aber nicht so schnell tun, dass die Messung dadurch beeinträchtigt wird. Wenn nun die Energie im wesentlichen im Innern des Gefässes 2 und nicht in der Nähe der Aussenwand 9 in Wärme umgesetzt wird, dann dauert es in der Regel mehrere Sekunden, bis die zugeführte Wärme aufgrund der Wärmeleitung über die Aussenwand 9 abgeführt wird. In der Praxis reicht das, um den endgültigen Wert der Steighöhe zu bestimmen.

Ein weiterer Störeffekt den es zu unterbinden gibt, ist die thermische Ausdehnung des Gefässes 2. Dieser hängt davon ab, wie stark sich einerseits das Gefäss 2 wegen des durchgehenden Mikrowellenpulses erwärmt und wie gross andererseits sein Ausdehnungskoeffizient ist. Im Hinblick auf einen geringen Ausdehnungskoeffizienten ist es daher von Vorteil, ein Gefäss aus Quarz einzusetzen. Eine kostengünstigere Möglichkeit besteht darin, ein Glas mit einer hohen Transparenz für die zu messenden Mikrowellenpulse zu wählen. Auf jeden Fall ist es aber gut, das Gefäss 2 so dünnwandig wie möglich zu halten.

Es versteht sich, dass beim Einfüllen der Absorberflüssigkeit 3 in das Gefäss 2 darauf zu achten ist, dass sich keine Luft oder Gaseinschlüsse bilden, welche die korrekte Funktionsweise der Anordnung verhindern.

Wenn die Kapillare 4 auswechselbar angebracht ist, kann die Anordnung z.B. durch Einsetzen einer grösseren Kapillare 4 sehr schnell auf Mikrowellenpulse höherer Energie umgerüstet werden. Mit Hilfe des Ausgleichsvolumen 5 lässt sich die Steighöhe jeweils wieder nivellieren.

Ist die Absorberflüssigkeit 3 zähflüssig, so kann es vorkommen, dass die Kapillare 4, welche aufgrund der zu erwartenden kleinen thermischen Volumenausdehnung einzusetzen wäre, zu dünn ist für die Absorberflüssigkeit 3. In einem solchen Fall wird auf die Absorberflüssigkeit 3 ein dünnflüssiges Medium aufgegossen, dessen spezifisches Gewicht geringer ist als das der Absorberflüssigkeit 3.

Die Zunahme der Steighöhe kann ohne weiteres von Auge abgelesen werden, denn das Abfliessen der zugeführten Wärme und damit das Absinken der Steighöhe geht sehr langsam vor sich. Komfortabler ist es allerdings, wenn die Steighöhe automatisch gemessen wird. Beispielsweise kann die Kapillare optisch auf einen CCD Arrey abgebildet werden, welcher elektronisch ausgelesen wird, oder die Steighöhe kann akustisch gemessen werden, indem im luftgefüllten Teil der Kapillare 4 eine stehende Welle erzeugt wird.

Ein Nachteil der in Fig. 1 gezeigten Anordnung besteht darin, dass Energie, welche an den Reflektorkonus 6 abgegeben wird nicht in die Messung einbezogen wird. Dies wird sich vornehmlich bei höheren Energien auswirken.

Diesem Nachteil kann abgeholfen werden, wenn das Gefäss 2 wie in Fig. 2 oder Fig. 3 gezeigt geformt ist.

Fig. 2 zeigt eine Anordnung, bei welcher das Gefäss 2 eine konische Einbuchtung als HF-Fenster besitzt. Ein Volumen des Gefässes 2 wird begrenzt durch eine zylinderförmige Aussenwand 9, eine im Gegensatz zu Fig. 1 konische Innenwand 8, einem Boden 10 und eine Decke 11.

Der aus einem Wellenleiter 1 eingestrahlte Mikrowellenpuls läuft sich langsam tot, seine Energie wird auch hier auf die ganze Absorberflüssigkeit 3 verteilt.

Fig. 3 zeigt eine weitere bevorzugte Ausführungsform des Gefässes 2. Aussenwand 9, Boden 10 und Decke 11 entsprechen denjenigen von Fig. 2. Eine Innenwand 8 ist so geformt, dass sie im Axialschnitt M-förmig aussieht. Ein Mikrowellenpuls (siehe Pfeil), dessen Energiedichte beispielsweise beim halben Radius des Wellenleiters 1 maximal ist, wird z.B. so absorbiert, dass sich die Energie in die Schultern des M-förmigen Axialschnitts verläuft.

Die übrigen in Fig. 2 und 3 bezeichneten Elemente (Kapillare 4, Reflexionsschicht 12 usw.) entsprechen den bereits beschriebenen und in Fig. 1 gleichnahmig bezeichneten. Die restlichen in Fig. 1 gezeigten Teile, welche in Fig. 2 und 3 nicht eingezeichnet sind, finden aber auch hier ihre Entsprechungen.

Fig. 4 zeigt eine Ausführungsform, welche in Zusammenhang mit einem rechteckigen Wellenleiter geeignet ist. Das Gefäss 2 ist ein Rohr, welches unter einem schiefen Winkel in den Wellenleiter 1 eingeschoben wird. An einem aus dem Wellenleiter 1 herausragenden Teil des Rohres sind die Kapillare 4 und das Ausgleichsvolumen 5 angebracht.

Unter welchem Winkel das Gefäss 2 in den Wellenleiter 1 hineinragen soll geht z.B. aus der eingangs zitierten Druckschrift von Horst Groll hervor.

Zusammenfassend kann gesagt werden, dass die Energie eines Mikrowellenpulses über die thermische Volumenausdehnung einer Absorberflüssigkeit gemessen wird. Der Form des Gefässes 2 und insbesondere der Form der als HF-Fenster dienenden Innenwand 8 kommt eine grosse Bedeutung zu. Für eine optimale Transmission muss sie jeweils auf den Mikrowellenpuls resp. die geleitete Mode des Wellenleiters 1 abgestimmt sein. In diesem Sinn sind die beschriebenen Ausführungsbeispiele als wegweisend, nicht aber als umfassend zu betrachten. Im Prinzip arbeitet die erfindungsgemässe Anordnung mit jeder Gefässform.

## Patentansprüche

1. Anordnung zum Messen der Pulsenergie eines Mikrowellenpulses, umfassend
(a) ein mit einem für Mikrowellen durchlässigen Fenster abgeschlossenes Gehäuse, welches in seinem Inneren ein erstes, Mikrowellen absorbierendes Medium enthält und an einen Mikrowellenleiter (1) angekoppelt werden kann;
(b) in dem Gehäuse ein abgeschlossenes Volumen mit einem zweiten Medium, welches mit dem ersten Medium in thermischem Kontakt steht und sich bei Absorption eines Mikrowellenpulses im ersten Medium volumenmässig ausdehnt; und
(c) eine Kapillare (4) zur Anzeige der Volumenausdehnung, welche Kapillare (4) mit dem abgeschlossenen Volumen in Verbindung steht;
dadurch gekennzeichnet, dass
(d) das erste und zweite Medium ein gemeinsames Medium in Form einer Absorberflüssigkeit (3) bilden;
(e) als Absorberflüssigkeit (3) ein nichtgasendes Oel, vorzugsweise ein Hydraulik- oder Vakuumoel, verwendet wird;
(f) das Gehäuse ein Gefäss (2) zur Aufnahme der Absorberflüssigkeit (3) ist, welches die Form eines Zylindermantels hat, eine Innenwand (8) und eine Aussenwand (9) aufweist und mit seiner Zylinderachse parallel zur Ausbreitungsrichtung der zu messenden Mikrowellen angeordnet ist;
(g) die Innenwand (8) als HF-Fenster (7) und die Aussenwand (9) für Mikrowellen reflektierend ausgebildet ist; und
(h) die Dicke des Gefässes (2) zwischen Innenwand (8) und Aussenwand (9) so gewählt ist, dass ein durch das Gefäss (2) laufender Mikrowellenpuls spätestens nach zweimaligem Durchlauf vollständig absorbiert wird.

2. Anordnung nach Anspruch 1, dadurch gekennzeichnet, dass im Inneren des Gefässes (2) ein Reflektorkonus (6) angeordnet ist.

3. Anordnung nach Anspruch 1, dadurch gekennzeichnet, dass die Innenwand (8) konisch ausgebildet ist.

4. Anordnung nach Anspruch 1, dadurch gekennzeichnet, dass die Innenwand (8) so geformt ist, dass sie im Axialschnitt M-förmig aussieht.

5. Anordnung nach einem der Ansprüche 1 bis 4, dadurch gekennzeichnet, dass das Gefäss (2) mit einem Ausgleichsvolumen (5) in Verbindung steht, so dass über das Ausgleichsvolumen (5) eine Steighöhe in der Kapillare (4) nivelliert werden kann.

6. Anordnung nach einem der Ansprüche 1 bis 5, dadurch gekennzeichnet, dass
(a) das Gefäss (2) dünnwandig ist;
(b) zumindest die Aussenwand (9) mit einer Reflexionsschicht (12) versehen ist;
(c) die Absorberflüssigkeit (3) ein Volumen hat, welches so gross ist, dass die Zunahme des Wärmegehaltes bei der Absorption eines Mikrowellenpulses nur zu einer unwesentlichen Erhöhung der Arbeitstemperatur führen kann; und
(d) das Gefäss (2) aus einem Material mit einem geringen thermischen Ausdehnungskoeffizienten besteht.

7. Anordnung nach einem der Ansprüche 1 bis 6, dadurch gekennzeichnet, dass die Steighöhe in der Kapillare (4) durch ein dünnflüssiges Medium angezeigt wird, welches auf die Absorberflüssigkeit (3) aufgegossen ist und sich mit der Absorberflüssigkeit (3) nicht vermischt.

8. Anordnung nach einem der Ansprüche 1 bis 7, dadurch gekennzeichnet, dass das Gefäss (2) mit Mitteln zur Konstanthaltung der Arbeitstemperatur, vorzugsweise in Form einer um das Gehäuse (2) gewickelten Kühlschlange (14), versehen ist.

## Claims

1. Arrangement for measuring the pulse energy of a microwave pulse, comprising
(a) a housing which is sealed by a window transparent to microwaves, contains in its interior a first medium absorbing microwaves, and can be coupled to a microwave waveguide (1);
(b) in the housing, a sealed volume having a second medium which is thermal contact with the first medium and in the event of absorption of a microwave pulse in the first medium expands volumetrically; and
(c) a capillary (4) for indicating the volumetric expansion, which capillary (4) is connected to the sealed volume;
characterised in that
(d) the first and second medium form a common medium in the form of an absorber liquid (3);
(e) a non-gassing oil, preferably a hydraulic oil or vacuum oil, is used as absorber liquid (3);
(f) the housing is a vessel (2) for accommodating the absorber liquid (3), which housing has the form of a cylindrical casing, an inner wall (8) and an outer wall (9) and is arranged with its cylinder axis parallel to the direction of propagation of the microwaves to be measured;
(g) the internal wall (8) is constructed as an RF window (7) and the outer wall (9) is constructed to be reflective for microwaves; and
(h) the thickness of the vessel (2) between the inner wall (8) and outer wall (9) is selected in such a way that a microwave pulse passing through the vessel (2) is completely absorbed at the latest after a two-fold traverse.

2. Arrangement according to Claim 1, characterised in that a reflector cone (6) is arranged in the interior of the vessel (2).

3. Arrangement according to Claim 1, characterised in that the internal wall (8) is constructed conically.

4. Arrangement according to Claim 1, characterised in that the internal wall (8) is shaped in such a way that it looks like an M in axial section.

5. Arrangement according to one of Claims 1 to 4, characterised in that the vessel (2) is connected to a balancing volume (5), so that a rise height in the capillary (4) can be levelled via the balancing volume (5).

6. Arrangement according to one of Claims 1 to 5, characterised in that
(a) the vessel (2) is thin-walled;
(b) at least the outer wall (9) is provided with a reflective layer (12);
(c) the absorber liquid (3) has a volume which is so large that the increase in the heat content upon the absorption of a microwave pulse can lead only to an insubstantial increase in the working temperature; and
(d) the vessel (2) consists of a material having a low coefficient of thermal expansion.

7. Arrangement according to one of Claims 1 to 6, characterised in that the rise height in the capillary (4) is indicated by a thin medium which is poured onto the absorber liquid (3) and does not mix with the absorber liquid (3).

8. Arrangement according to one of Claims 1 to 7, characterised in that the vessel (2) is provided with means for keeping the working temperature constant, preferably in the form of a cooling grid (14) wrapped around the housing (2).

## Revendications

1. Dispositif de mesure de l'énergie d'une impulsion de micro-ondes, comprenant :
a) un boîtier fermé par une fenêtre perméable aux micro-ondes, qui contient un premier agent absorbant les micro-ondes et peut être couplé à un guide de micro-ondes (1);
b) dans le boîtier, un volume fermé avec un second agent, qui est en contact thermique avec le premier agent et dont le volume se dilate lorsqu'il y a absorption d'une impulsion de micro-ondes dans le premier agent, et
c) un capillaire (4) pour indiquer la dilatation du volume, ce capillaire (4) étant en liaison avec le volume fermé;
caractérisé en ce que :
d) le premier et le second agent forment un agent commun sous la forme d'un liquide absorbant (3);
e) on utilise comme liquide absorbant (3) une huile ne dégageant pas de gaz, de préférence, une huile hydraulique ou une huile vacuum;
f) le boîtier est un récipient (2) destiné à recevoir le liquide absorbant (3), ayant la forme d'une enveloppe cylindrique, comportant une paroi intérieure (8) et une paroi extérieure (9) et étant agencé avec son axe de cylindre parallèle à la direction de propagation des micro-ondes à mesurer;
g) la paroi intérieure (8) est conformée en fenêtre HF (7) et la paroi extérieure (9) réfléchit les micro-ondes, et
h) l'épaisseur du récipient (2) entre la paroi intérieure (8) et la paroi extérieure (9) est choisie telle qu'une impulsion de micro-ondes traversant le récipient (2) soit complètement absorbée au plus tard après le second passage.

2. Dispositif selon la revendication 1, caractérisé en ce qu'un cône réflecteur (6) est disposé à l'intérieur du récipient (2).

3. Dispositif selon la revendication 1, caractérisé en ce que la paroi intérieure (8) a une forme conique.

4. Dispositif selon la revendication 1, caractérisé en ce que la paroi intérieure (8) est conformée de manière à avoir en coupe axiale une forme en M.

5. Dispositif selon l'une quelconque des revendications 1 à 4, caractérisé en ce que le récipient (2) est en liaison avec un volume de compensation (5) de sorte que, via le volume de compensation (5), on peut niveler la hauteur d'aspiration dans le capillaire (4).

6. Dispositif selon l'une quelconque des revendications 1 à 5, caractérisé en ce que :
a) le récipient (2) a une paroi mince;
b) au moins la paroi extérieure (9) est dotée d'une couche réfléchissante (12);
c) le liquide absorbant (3) a un volume qui est si grand que l'augmentation de la chaleur y contenue lors de l'absorption d'une impulsion de micro-ondes ne puisse entraîner qu'une augmentation peu sensible de la température de travail, et
d) le récipient (2) est fait d'une matière présentant un coefficient de dilatation thermique faible.

7. Dispositif selon l'une quelconque des revendications 1 à 6, caractérisé en ce que la hauteur d'aspiration dans le capillaire (4) est indiquée par un agent fluide, qui est versé sur le liquide absorbant (3) et ne se mélange pas à celui-ci.

8. Dispositif selon l'une quelconque des revendications 1 à 7, caractérisé en ce que le récipient (2) est doté de moyens pour maintenir constante la température de travail, de préférence sous la forme d'un serpentin de refroidissement (14) enroulé autour du boîtier (2).
